# DEMANDE DE BREVET EUROPEEN

(11) **EP 1 427 005 A1**
(43) Date de publication de la demande: **09.06.2004**
(21) Numéro de dépôt: 03292872.3
(22) Date de dépôt: 19.11.2003
(51) Int. Cl.: H01L 21/316, C23C 16/40

(54) **Procédé et dispositif de réalisation d'un couche de pentoxyde de tantale sur un matériau porteur en particulier du nitrure de titane et circuit intégré incorporant une couche de pentoxyde de tantale**

(30) Priorité: 26.11.2002 FR 0214798
(71) Demandeur: STMicroelectronics S.A., 92120 Montrouge (FR)
(72) Inventeur: Gros-Jean, Mickael, 38000 Grenoble (FR); Jourdan, Nicolas, 38000 Grenoble (FR); Michailos, Jean, 38240 Meylan (FR)
(74) Mandataire: Casalonga, Axel

(57) **Abrégé**

On chauffe (MCH) le matériau porteur (PL) à une température de chauffage comprise entre 200°C et 400°C, et on fait circuler au contact du matériau porteur chauffé un mélange gazeux (MG) contenant du tertiobutylimino-tris-diethyl amino tantale (t-BuN=Ta(NEt₂)₃) sous atmosphère oxydante, la pression partielle du tertiobutylimino-tris-diethyl amino tantale étant supérieure ou égale à 25 mTorr.

## Description

L'invention concerne les circuits intégrés, et plus particulièrement la réalisation d'une couche de pentoxyde de tantale (Ta₂O₅) sur un matériau porteur, par exemple du nitrure de titane.

Le précurseur classique de tantale pour le dépôt de pentoxyde de tantale est le pentaethoxyde de tantale (Ta(OEt)₅) connu également de l'homme du métier sous l'abréviation anglosaxonne TAETO. Actuellement, on utilise le précurseur TAETO pour la fabrication des condensateurs des mémoires DRAM dans des technologies 0,18 microns ou plus. En effet, de telles technologies supportent bien des budgets thermiques importants, occasionnés en particulier par la température élevée (bien supérieure à 400 °C) de dépôt du TAETO.

Cependant, alors que les condensateurs des cellules-mémoire DRAM sont fabriqués en début de process, les condensateurs métal-isolant-métal (condensateurs MIM) sont typiquement des condensateurs réalisés en fin de process de fabrication du circuit intégré, et, par exemple après le niveau de métal 4. Et, la réalisation de ces condensateurs doit s'effectuer sous un budget thermique beaucoup plus faible, de façon à ne pas détériorer les autres composants du circuit intégré, déjà réalisés.

De même, les technologies beaucoup plus avancées, par exemple les technologies inférieures à 0,1 micron, supportent d'une façon générale des budgets thermiques beaucoup plus faibles, typiquement inférieur ou égal à 400 °C.

Par ailleurs, la formation de pentoxyde de tantale sur du silicium conduit à la formation d'une couche de dioxyde de silicium ayant une faible constante diélectrique. Il en résulte alors une diminution de la capacité totale du condensateur réalisé.

Aussi, est-il envisagé de former du pentoxyde de tantale sur du nitrure de titane (TiN). Cependant, si le nitrure de titane est porté à une température trop élevée lors de la formation du pentoxyde de tantale, ce qui est le cas avec l'utilisation d'un précurseur tel que TAETO, il se produit alors une réaction entre l'oxygène et le nitrure de titane, ce qui provoque une dégradation de l'interface entre le nitrure de titane et le pentoxyde de tantale.

Pour toutes ces raisons, il est envisagé d'utiliser un autre précurseur que le TAETO.

A cet égard, des essais ont été effectués à une température de l'ordre de 400 °C, avec, comme précurseur, du tétraoxyde diméthylamino éthoxyde tantale, également connu par l'homme du métier sous son abréviation anglosaxonne de TATDMAE (Ta(OEt)₄(OCH₂CH₂NME₂).

Cependant, au vu de certains essais effectués on obtient un diélectrique de pentoxyde de tantale de très mauvaise qualité, voire de qualité encore moins bonne que celle obtenue avec du TAETO comme précurseur.

On connaît également en tant que précurseur organométallique, du tertiobutylimino-tris-diéthyl amino tantale (t-BuN=Ta(NEt₂)₃) également connu par l'homme du métier sous son abréviation anglosaxonne de TBTDET (t-Butylimino trisdiethylamino Tantalum).

Le précurseur TBTDET se décompose à plus basse température que le précurseur TAETO. Il a été de ce fait utilisé pour former des couches de nitrure de tantale (TaN). De nombreux brevets ont décrit cette utilisation. On peut citer à cet égard les brevets américains n° 5 668 054, n° 6 153 519, n° 6 215 189, n° 6 265 311, n° 6 268 288, n° 6 376 371, n° 6 410 432, n° 6 410 433, n° 6413 860, n° 6 416 822, et n° 6 428 859.

Des expérimentations ont par ailleurs été effectuées pour former du pentoxyde de tantale en utilisant comme précurseur le précurseur organométallique TBTDET. Cependant, ces expérimentations s'avèrent décevantes et non satisfaisantes car le diélectrique ainsi obtenu est de mauvaise qualité. En d'autres termes, un condensateur dont le diélectrique serait formé de pentoxyde de tantale obtenu actuellement en utilisant du TBTDET comme précurseur, présenterait des courants de fuite importants, ce qui est totalement inacceptable pour une intégration dans un circuit intégré.

En outre, l'homme du métier sait que la fabrication d'un circuit intégré nécessite à différents stades du processus de fabrication, des traitements thermiques, tels que des recuits.

Or, il s'est avéré que les couches de pentoxyde de tantale réalisées jusqu'alors de façon expérimentale, étaient thermodynamique ment instables. Plus précisément, même si une couche réalisée à une température donnée présentait une qualité acceptable en termes de courant de fuite, l'application, sur une telle couche incorporée dans un circuit intégré, de traitements ultérieurs, tels que des traitements thermiques de recuit, des gravures, ... conduisait au final à une couche fortement dégradée en termes de courant de fuite. En conséquence, les expérimentations effectuées jusqu'à maintenant pour obtenir du pentoxyde de tantale avec du TBTDET comme précurseur, sont totalement incompatibles avec l'intégration d'une telle couche de diélectrique dans un circuit intégré.

L'invention vise à apporter une solution à ces problèmes.

Un but de l'invention est de former du pentoxyde de tantale à basse température, thermodynamiquement stable et de bonne qualité.

L'invention a encore pour but la réalisation d'une couche de pentoxyde de tantale qui puisse être incorporée au sein d'un circuit intégré.

L'invention a encore pour but de permettre la réalisation d'un diélectrique plus élastique, et supportant mieux les contraintes mécaniques.

Un but de l'invention est de permettre également la production d'un diélectrique avec une qualité élevée de germination.

L'invention propose donc un procédé de formation d'une couche de pentoxyde de tantale (Ta₂O₅) sur un matériau porteur. Selon une caractéristique générale de l'invention, on chauffe le matériau porteur à une température de chauffage comprise entre 200 °C et 400 °C, et on fait circuler au contact du matériau porteur chauffé, un mélange gazeux contenant du tertiobutylimino-tris-diéthyl amino tantale (t-BuN=Ta(NEt₂)₃), sous atmosphère oxydante, la pression partielle du tertiobutylimino-tris-diéthyl amino tantale étant supérieure ou égale à 25 mTorr.

Ainsi, selon l'invention, la combinaison
- du précurseur organométalique TBTDET,
- d'une température basse, préférentiellement comprise entre 300 °C et 350 °C, et
- d'une pression partielle élevée de TBTDET,
permet d'obtenir à basse température du pentoxyde de tantale de bonne qualité vis-à-vis des courants de fuite. Ainsi, à titre indicatif, sous l'application d'une tension égale en valeur absolue à 3,6 volts environ aux bornes du diélectrique, le courant de fuite mesuré en ampères par cm² surfacique de diélectrique est inférieur à 10^{-((x+20)/10)}, x étant l'épaisseur de pentoxyde de tantale mesurée en nanomètres et ce pour des épaisseurs allant de 25 à 65 nanomètres.

Le contrôle de la pression partielle du précurseur TBTDET permet de contrôler la vitesse de dépôt et la qualité de la nucléation (ou germination).

Ainsi, lorsqu'on augmente la pression partielle de TBTDET, on augmente alors la vitesse de dépôt, ce qui permet de limiter la durée d'exposition du matériau porteur au contact du milieu oxydant, par exemple de l'oxygène. Ceci est particulièrement avantageux lorsque le matériau porteur est du nitrure de titane mais également lorsqu'il s'agit de silicium. En effet, dans le cas d'un matériau porteur en nitrure de titane, on minimisera grandement la dégradation de l'interface entre le nitrure de titane et le pentoxyde de tantale. Dans le cas d'un matériau porteur en silicium, on minimisera la couche de dioxyde de silicium formée à l'interface entre le pentoxyde de tantale et le silicium.

Par ailleurs, l'augmentation de la pression partielle du précurseur organométallique utilisé, et par conséquent l'augmentation de la vitesse de dépôt, permet d'obtenir un matériau diélectrique moins dense, et par conséquent plus élastique. Aussi, ce matériau diélectrique supportera mieux les contraintes mécaniques qui se produisent notammant lors du refroidissement des plaques de matériau porteur.

L'augmentation de la pression partielle du précurseur organométallique permet d'augmenter la qualité de la germination du pentoxyde de tantale sur le matériau porteur, en particulier sur le silicium et le nitrure de titane. L'apparition de la croissance tridimensionnelle du pentoxyde de tantale est donc plus rapide.

Il a été observé qu'une valeur de 25 mTorr pour cette pression partielle de TBTDET constituait une limite inférieure acceptable compatible avec une qualité suffisante du diélectrique ainsi formé et avec son intégration dans un circuit intégré.

Ceci étant, des pressions partielles plus élevées permettent d'améliorer encore la qualité du diélectrique.

A cet égard, bien qu'il n'existe pas théoriquement de limite supérieure pour la pression partielle du précurseur organométallique utilisé, il est toutefois souhaitable, lorsqu'on fait circuler le mélange gazeux dans une chambre dans laquelle est placé le matériau porteur, que la pression partielle du tertiobutylimino-tris-diéthyl amino tantale soit inférieure à la pression de vapeur de ce tertiobutylimino-tris-diéthyl amino tantale correspondant à la température du point le plus froid de la chambre.

En effet, l'homme du métier sait que la pression de vapeur d'un gaz à une température donnée est la pression au-delà de laquelle le gaz se transforme en phase liquide. Aussi, si la pression partielle du TBTDET devient supérieure à la pression de vapeur du TBTDET correspondant à la température du point le plus froid de la chambre, il va alors se produire un début de condensation sur les parois de la chambre. Bien que ceci ne remette pas en cause les avantages obtenus par l'invention, cette condensation peut être gênante dans certaines applications et c'est la raison pour laquelle il est alors préférable que la pression partielle du TBTDET soit inférieure à cette pression de vapeur correspondant au point le plus froid de la chambre.

A titre indicatif, on pourra choisir une pression partielle de TBTDET comprise entre 65 mTorr et 70 mTorr. Une telle fourchette est par ailleurs parfaitement compatible avec une chambre dont le point froid se situe à 90 °C, ce qui correspond alors à une pression de vapeur du TBTDET égale à 75 mTorr.

Le TBTDET peut être mélangé à toute atmosphère oxydante (O₂, O₃, H₂O ou autre). On utilisera toutefois préférentiellement de l'oxygène.

Le mélange gazeux contient également avantageusement un gaz porteur, par exemple de l'azote ou de l'argon.

La vitesse des gaz, ou le temps de renouvellement des gaz sur le matériau porteur, permet d'affiner l'uniformité du dépôt de pentoxyde de tantale. Ce temps de renouvellement peut être ajusté en fonction de la machine utilisée et de l'application envisagée. Ainsi, lorsqu'on fait circuler le mélange gazeux dans une chambre dans laquelle est placé le matériau porteur, on choisira par exemple un temps de renouvellement du mélange gazeux dans la chambre compris entre 0,1 seconde et 10 minutes. Ceci étant, à titre indicatif, pour l'obtention d'un dépôt uniforme de quelques dizaines de nanomètres, par exemple 44 nanomètres, on pourra choisir un temps de renouvellement de l'ordre de 1 à 10 secondes, et préférentiellement de l'ordre de 1 à 3 secondes.

Le choix du matériau porteur est extrêmement large.

Ainsi, le matériau porteur peut être un matériau semi-conducteur, par exemple un substrat de silicium.

Le matériau porteur peut être également un matériau métallique, par exemple un matériau choisi dans le groupe formé par le nitrure de titane (TiN), le nitrure de tantale (TaN), le cuivre, le platine, l'aluminium, le titane, le tantale, le ruthénium (Ru). De tels matériaux métalliques peuvent former ainsi les électrodes métalliques d'un condensateur intégré dans un circuit intégré.

Le matériau porteur peut être aussi un matériau diélectrique, par exemple un matériau choisi dans le groupe formé par le dioxyde de silicium, le nitrure de silicium (Si₃N₄), l'alumine (Al₂O₃), ZrO₂, HfO₂.

En pratique, l'épaisseur de la couche de pentoxyde de tantale formée peut être de l'ordre de quelques dizaines de nanomètres, par exemple 44 nanomètres.

Par ailleurs, le matériau porteur peut être en pratique disposé sur une plaquette circulaire ayant un diamètre de 200 mm ou 300 mm.

La couche de pentoxyde de tantale ainsi formée peut être destinée à être incorporée dans un ou plusieurs circuits intégrés électroniques.

L'invention a également pour objet un dispositif de formation d'une couche de pentoxyde de tantale sur un matériau porteur, comportant des moyens de chauffage aptes à chauffer le matériau porteur, et des moyens d'injection aptes à faire circuler un mélange gazeux au contact du matériau porteur chauffé.

Selon une caractéristique générale de l'invention, les moyens de chauffage sont aptes à chauffer le matériau porteur à une température de chauffage comprise entre 200°C et 400°C, et le mélange gazeux contient du tertiobutylimino-tris-diethyl amino tantale (t-BuN=Ta(NEt₂)₃) sous atmosphère oxydante, la pression partielle du tertiobutylimino-tris-diethyl amino tantale étant supérieure ou égale à 25 mTorr.

Selon un mode de réalisation de l'invention, le dispositif comporte une chambre dans laquelle est placé le matériau porteur, et la pression partielle du tertiobutylimino-tris-diethyl amino tantale est inférieure à la pression de vapeur du tertiobutylimino-tris-diethyl amino tantale correspondant à la température du point le plus froid de la chambre.

Le matériau porteur peut être disposé sur une plaquette circulaire ayant par exemple un diamètre de 200 mm ou 300 mm.

Selon un mode de réalisation de l'invention, la chambre peut contenir une seule plaquette, ou bien plusieurs plaquettes.

L'invention a également pour objet un circuit intégré comprenant au moins un condensateur comportant du pentoxyde de tantale disposé entre deux électrodes et obtenu par le procédé tel que défini ci-avant.

Selon un mode de réalisation dans lequel le pentoxyde de tantale a une épaisseur x comprise entre environ 25 nanomètres et 65 nanomètres, le pentoxyde de tantale présente, sous une différence de tension appliquée entres les deux électrodes égale en valeur absolue à 3,6 volts environ, un courant de fuite mesuré en Ampères par cm2 de surface de pentoxyde de tantale, inférieur à 10^{-((x+20)/10)}.

Les électrodes du condensateur peuvent comporter du nitrure de titane au contact du pentoxyde de tantale.

Les électrodes peuvent comporter également un matériau semi-conducteur, par exemple du silicium.

Les électrodes peuvent comporter encore un matériau métallique, par exemple un matériau pris dans le groupe formé par le nitrure de tantale, le cuivre, le platine, l'aluminium, le titane, le tantale, le ruthénium.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre très schématiquement un premier mode de réalisation d'un dispositif selon l'invention permettant une mise en oeuvre du procédé selon l'invention,
- la figure 2 illustre très schématiquement et partiellement un deuxième mode de réalisation d'un dispositif selon l'invention,
- la figure 3 illustre schématiquement un circuit intégré selon l'invention, et,
- le figure 4 illustre très schématiquement une mesure de courant de fuite d'une couche de pentoxyde de tantale obtenue par le procédé selon l'invention.

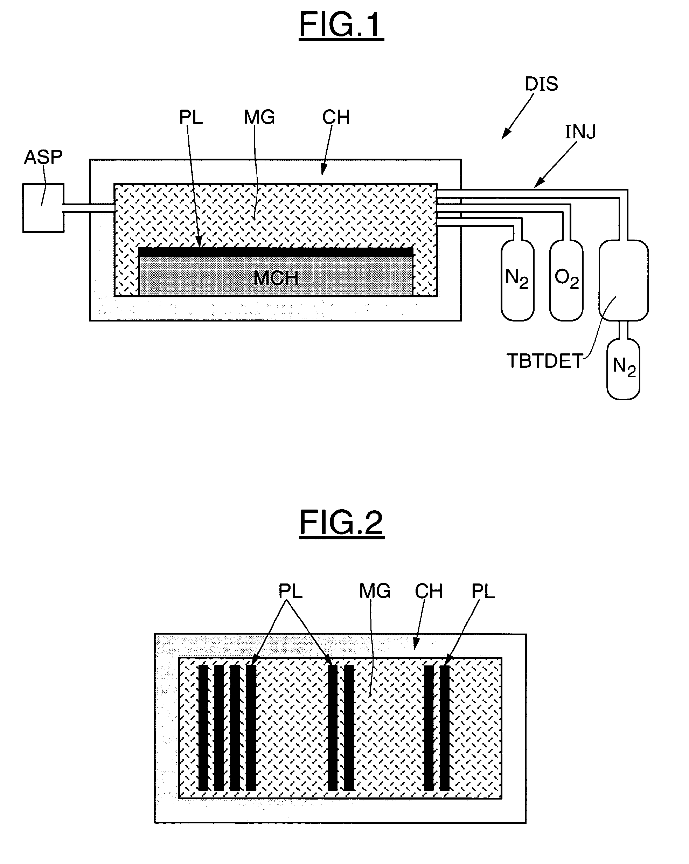

Sur la figure 1, la référence DIS désigne un dispositif destiné à former une couche de pentoxyde de tantale (Ta₂O₅) sur la surface supérieure d'une plaque PL formée d'un matériau porteur, par exemple une plaque recouverte de nitrure de titane (TiN).

Cette plaque est placée dans une chambre CH et est chauffée par des moyens de chauffage MCH formés ici d'un support chauffant.

Ceci étant, ces moyens de chauffage peuvent être de toute nature.

Des moyens d'injection INJ, qui peuvent être formés d'un moyen en forme de pomme de douche venant au-dessus de la plaque PL, ou bien formés de buses d'injection disposées sur les parois de la chambre, permettent d'injecter dans cette chambre et au contact du matériau porteur, un mélange gazeux MG comportant,
- en tant que précurseur organométallique, du TBTDET,
- de l'oxygène et
- un gaz porteur, par exemple de l'azote.

Des moyens d'aspiration ASP permettent, en combinaison avec les moyens d'injection, un renouvellement du mélange gazeux MG dans la chambre.

D'une façon générale, on chauffe le matériau porteur situé sur la surface supérieure de la plaque à une température de chauffage comprise entre 200 °C et 400 °C et on fait circuler le mélange gazeux MG au contact du matériau porteur ainsi chauffé, la pression partielle du TBTDET dans le mélange gazeux étant supérieure ou égale à 25 mTorr.

Le précurseur TBTDET va se décomposer et les groupements BuN et NEt₂ vont se détacher du tantale Ta pour être évacués via les moyens d'aspiration ASP. L'oxygène va alors se combiner avec le tantale pour former le pentoxyde de tantale Ta₂O₅.

Dans l'exemple décrit ici, le temps de renouvellement des gaz est de l'ordre de une à trois secondes. Des essais ont été effectués, respectivement à une température de chauffage de 360 °C et de 375 °C.

Pour une température de 360 °C, on a obtenu une couche uniforme de Ta₂O₅ en utilisant une pression partielle de TBTDET égale à 0,068 Torr, une pression partielle du gaz porteur (azote) égale à 8,6 Torr et une pression partielle d'oxygène égale à 3,57 Torr.

Pour une température de chauffage de 375 °C, la pression partielle de TBTDET peut être plus faible, par exemple prise égale à 0,04 Torr tandis que les pressions partielles d'azote et d'oxygène sont respectivement égales à 6,45 Torr et 5,51 Torr.

Les deux pressions partielles de TBTDET respectivement utilisées dans les deux exemples décrits ci-dessus, restent inférieures à 75 mTorr, ce qui correspond à la pression de vapeur de TBTDET pour une température de 90 °C qui constitue le point le plus froid de la chambre utilisée.

Dans ces conditions, on évite une condensation du TBTDET sur les parois de la chambre.

Alors que dans l'exemple illustré sur la figure 1, la chambre ne comporte qu'une seule plaque, qui peut être formée d'un disque de 200 mm ou de 300 mm de diamètre par exemple, on peut envisager d'utiliser une chambre CH telle que celle illustrée sur la figure 2 dans laquelle plusieurs plaques PL, disposées verticalement, peuvent être mises au contact du mélange gazeux MG.

Les applications de l'invention sont multiples.

On peut ainsi citer notamment les structures de condensateurs métal/diélectrique/semi-conducteur (structures MIS) ou bien les structures de condensateurs métal/diélectrique/métal (structures MIM) pour les applications de mémoire vive dynamique.

On peut également citer les structures MIS ou MIM pour les applications de condensateurs analogiques ou radiofréquence ou encore pour les condensateurs à tranchée profonde.

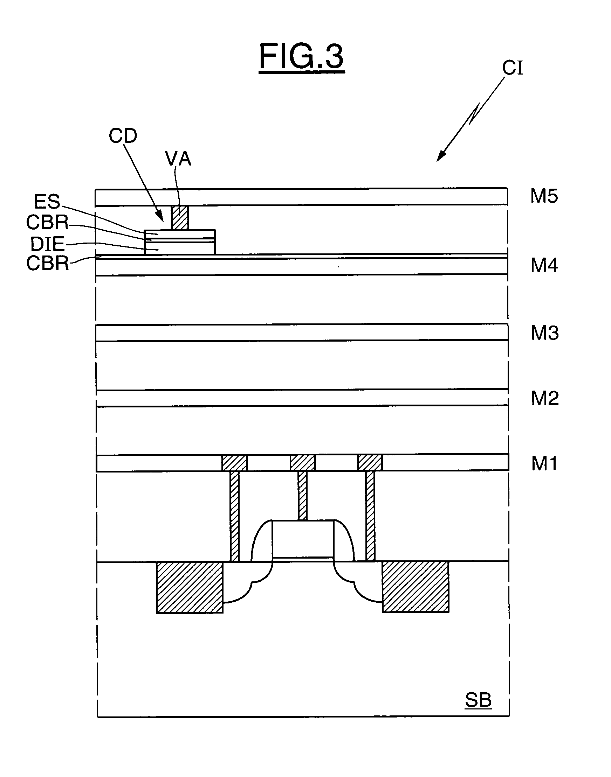

Un exemple de circuit intégré comportant un condensateur dont le diélectrique est obtenu par le procédé selon l'invention est illustré sur la figure 3.

Ce circuit intégré comporte de façon classique, sur un substrat SB, des composants actifs, par exemple des transistors. Le circuit intégré comporte également plusieurs niveaux de métallisation M1-M5. Par ailleurs, entre le niveau de métal 4 M4 et le niveau de métal 5 M5 est réalisé un condensateur CD. L'électrode inférieure de ce condensateur CD est formée par une partie du niveau de métal 4 recouverte d'une couche barrière CBR en nitrure de titane. L'électrode supérieure ES est une électrode métallique, par exemple en aluminium ou en cuivre, également recouverte sur sa face inférieure d'une couche barrière CBR en nitrure de titane. Le diélectrique DIE, formé de pentoxyde de tantale, est disposé entre les deux couches de nitrure de titane. L'électrode supérieure ES est reliée au niveau de métallisation supérieur M5 par un via VA.

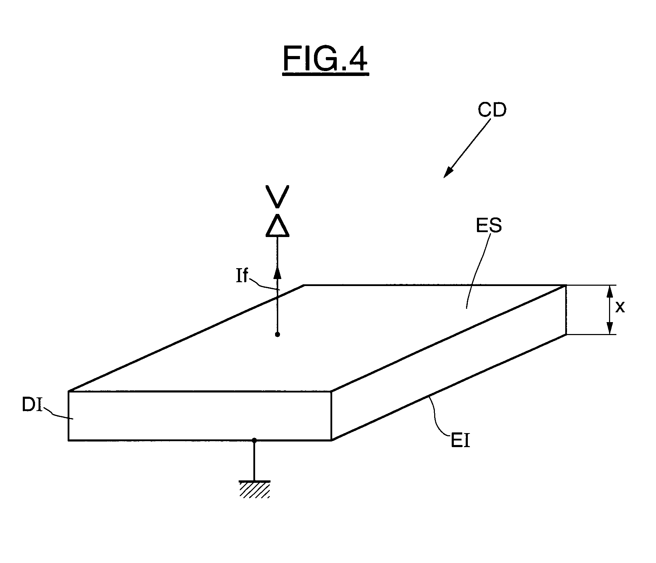

Une couche de pentoxyde de tantale obtenue par le procédé selon l'invention présente la particularité d'être de très bonne qualité vis-à-vis des courants de fuite. Plus précisément, comme illustré sur la figure 4, si l'on applique entre les deux électrodes ES et EI d'un condensateur CD dont le diélectrique DI est formé de pentoxyde de tantale obtenu par le procédé selon l'invention, une différence de tension V égale en valeur absolue à 3,6 volts environ, on observera un courant de fuite If inférieur à 10^{-((x+20)/10)}, où x désigne l'épaisseur de la couche de diélectrique, exprimée en nanomètres. Par ailleurs, dans cette formule, le courant If est exprimé en ampères par centimètre carré de surface de pentoxyde de tantale.

## Revendications

1. Procédé de formation d'une couche de pentoxyde de tantale (Ta₂O₅) sur un matériau porteur, **caractérisé par le fait qu'**on chauffe (MCH) le matériau porteur (PL) à une température de chauffage comprise entre 200°C et 400°C, et on fait circuler au contact du matériau porteur chauffé un mélange gazeux (MG) contenant du tertiobutylimino-tris-diethyl amino tantale (t-BuN=Ta(NEt₂)₃) sous atmosphère oxydante, la pression partielle du tertiobutylimino-tris-diethyl amino tantale étant supérieure ou égale à 25 mTorr.

2. Procédé selon la revendication 1, **caractérisé par le fait que** la température de chauffage est comprise entre 300°C et 350°C environ.

3. Procédé selon la revendication 1 ou 2, **caractérisé par le fait qu'**on fait circuler le mélange gazeux (MG) dans une chambre (CH) dans laquelle est placé le matériau porteur (PL), et **par le fait que** la pression partielle du tertiobutylimino-tris-diethyl amino tantale est inférieure à la pression de vapeur du tertiobutylimino-tris-diethyl amino tantale correspondant à la température du point le plus froid de la chambre (CH).

4. Procédé selon l'une des revendications précédentes, **caractérisé par le fait que** la pression partielle du tertiobutylimino-tris-diethyl amino tantale est comprise entre 65 mTorr et 70 mTorr.

5. Procédé selon l'une des revendication précédentes, **caractérisé par le fait que** le mélange gazeux (MG) contient de l'oxygène.

6. Procédé selon l'une des revendications précédentes, **caractérisé par le fait que** le mélange gazeux (MG) contient un gaz porteur, par exemple de l'azote.

7. Procédé selon l'une des revendications précédentes, **caractérisé par le fait qu'**on fait circuler le mélange gazeux (MG) dans une chambre (CH) dans laquelle est placé le matériau porteur, et **par le fait que** le temps de renouvellement du mélange gazeux (MG) dans la chambre est compris entre 0,1 seconde et 10 minutes, par exemple de l'ordre de une à 10 secondes.

8. Procédé selon l'une des revendications précédentes, **caractérisé par le fait que** le matériau porteur (PL) est un matériau semi-conducteur, par exemple du silicium.

9. Procédé selon l'une des revendications 1 à 7, **caractérisé par le fait que** le matériau porteur (PL) est un matériau métallique.

10. Procédé selon la revendication 9, **caractérisé par le fait que** le matériau métallique est choisi dans le groupe formé par le nitrure de titane (TiN), le nitrure de tantale (TaN), le cuivre, le platine, l'aluminium, le titane, le tantale, le ruthénium (Ru).

11. Procédé selon l'une des revendications précédentes, **caractérisé par le fait que** le matériau porteur (PL) est un matériau diélectrique.

12. Procédé selon la revendication 11, **caractérisé par le fait que** le matériau diélectrique est choisi dans le groupe formé par le dioxyde de silicium (SiO₂), le nitrure de silicium (Si₃N₄), l'alumine (Al₂O₃), ZrO₂, HfO₂.

13. Procédé selon l'une des revendications précédentes, **caractérisé par le fait que** l'épaisseur de la couche de pentoxyde de tantale formée est de l'ordre de quelques dizaines de nanomètres, par exemple 44 nanomètres.

14. Procédé selon l'une des revendications précédentes, **caractérisé par le fait que** le matériau porteur (PL) est disposé sur une plaquette circulaire ayant un diamètre de 200 mm ou 300 mm.

15. Procédé selon l'une des revendications précédentes, **caractérisé par le fait que** la couche de pentoxyde de tantale est destinée à être incorporé dans un ou plusieurs circuits intégrés électroniques.

16. Dispositif de formation d'une couche de pentoxyde de tantale (Ta₂O₅) sur un matériau porteur, comportant des moyens de chauffage (MCH) aptes à chauffer le matériau porteur (PL), et des moyens d'injection (INJ) aptes à faire circuler un mélange gazeux au contact du matériau porteur chauffé, **caractérisé par le fait que** les moyens de chauffage (MCH) sont aptes à chauffer le matériau porteur à une température de chauffage comprise entre 200°C et 400°C, et **par le fait que** le mélange gazeux contient du tertiobutylimino-tris-diethyl amino tantale (t-BuN=Ta(NEt₂)₃) sous atmosphère oxydante, la pression partielle du tertiobutylimino-tris-diethyl amino tantale étant supérieure ou égale à 25 mTorr.

17. Dispositif selon la revendication 16, **caractérisé par le fait que** la température de chauffage est comprise entre 300°C et 350°C environ.

18. Dispositif selon la revendication 16 ou 17, **caractérisé par le fait qu'**il comporte une chambre (CH) dans laquelle est placé le matériau porteur, et **par le fait que** la pression partielle du tertiobutylimino-tris-diethyl amino tantale est inférieure à la pression de vapeur du tertiobutylimino-tris-diethyl amino tantale correspondant à la température du point le plus froid de la chambre.

19. Dispositif selon l'une des revendications 16 à 18, **caractérisé par le fait que** la pression partielle du tertiobutylimino-tris-diethyl amino tantale est comprise entre 65 mTorr et 70 mTorr.

20. Dispositif selon l'une des revendication 16 à 19, **caractérisé par le fait que** le mélange gazeux (MG) contient de l'oxygène.

21. Dispositif selon l'une des revendications 16 à 20, **caractérisé par le fait que** le mélange gazeux (MG) contient un gaz porteur, par exemple de l'azote.

22. Dispositif selon l'une des revendications 16 à 21, **caractérisé par le fait qu'**il comporte une chambre (CH) dans laquelle est placé le matériau porteur et dans laquelle circule le mélange gazeux, et **par le fait que** le temps de renouvellement du mélange gazeux dans la chambre est compris entre 0,1 seconde et 10 minutes, par exemple de l'ordre de une à dix secondes.

23. Dispositif selon l'une des revendications 16. à 22, **caractérisé par le fait que** le matériau porteur (PL) est un matériau semi-conducteur, par exemple du silicium.

24. Dispositif selon l'une des revendications 16 à 22, **caractérisé par le fait que** le matériau porteur (PL) est un matériau métallique.

25. Dispositif selon la revendication 24, **caractérisé par le fait que** le matériau métallique est choisi dans le groupe formé par le nitrure de titane (TiN), le nitrure de tantale (TaN), le cuivre, le platine, l'aluminium, le titane, le tantale, le ruthénium (Ru).

26. Dispositif selon l'une des revendications 16 à 22, **caractérisé par le fait que** le matériau porteur (PL) est un matériau diélectrique.

27. Dispositif selon la revendication 26, **caractérisé par le fait que** le matériau diélectrique est choisi dans le groupe formé par le dioxyde de silicium (SiO₂), le nitrure de silicium (Si₃N₄), l'alumine (Al₂O₃), ZrO₂ , HfO₂.

28. Dispositif selon l'une des revendications 16 à 27, **caractérisé par le fait que** l'épaisseur de la couche de pentoxyde de tantale formée est de l'ordre de quelques dizaines de nanomètres, par exemple 44 nanomètres.

29. Dispositif selon l'une des revendications 16 à 28, **caractérisé par le fait que** le matériau porteur (PL) est disposé sur une plaquette circulaire ayant un diamètre de 200 mm ou 300 mm.

30. Dispositif selon la revendication 29, **caractérisé par le fait que** la chambre (CH) contient une seule plaquette (PL).

31. Dispositif selon la revendication 29, **caractérisé par le fait que** la chambre (CH) contient plusieurs plaquettes (PL).

32. Dispositif selon l'une des revendications 16 à 31, **caractérisé par le fait que** la couche de pentoxyde de tantale est destinée à être incorporé dans un ou plusieurs circuits intégrés électroniques (CI).

33. Circuit intégré, **caractérisé par le fait qu'**il comprend au moins un condensateur (CD) comportant du pentoxyde de tantale disposé entre deux électrodes et obtenu par le procédé selon l'une des revendications 1 à 15.

34. Circuit intégré selon la revendication 33, **caractérisé par le fait que** le pentoxyde de tantale a une épaisseur x comprise entre environ 25 nanomètres et 65 nanomètres, et présente, sous une différence de tension appliquée entres les deux électrodes égale en valeur absolue à 3,6 volts environ, un courant de fuite mesuré en Ampères par cm2 de surface de pentoxyde de tantale, inférieur à 10^{-((x+20)/10)}.

35. Circuit intégré selon la revendication 33 ou 34, **caractérisé par le fait que** les électrodes comportent du nitrure de titane au contact du pentoxyde de tantale.

36. Circuit intégré selon la revendication 33, 34 ou 35, **caractérisé par le fait que** les électrodes comportent un matériau semi-conducteur, par exemple du silicium.

37. Circuit intégré selon la revendication 33, 34 ou 35, **caractérisé par le fait que** les électrodes comportent un matériau métallique.

38. Circuit intégré selon la revendication 37, **caractérisé par le fait que** les électrodes comportent un matériau pris dans le groupe formé par le nitrure de tantale (TaN), le cuivre, le platine, l'aluminium, le titane, le tantale, le ruthénium (Ru).

39. Circuit intégré selon l'une des revendications 33 à 38, **caractérisé par le fait que** l'épaisseur de la couche de pentoxyde de tantale formée est égale à 44 nanomètres.
